# EUROPÄISCHE PATENTSCHRIFT

(11) **EP 0 552 195 B1**
(45) Veröffentlichungstag und Bekanntmachung des Hinweises auf die Patenterteilung: **23.04.1997**
(21) Anmeldenummer: 91917356.7
(22) Anmeldetag: 09.10.1991
(51) Int. Cl.: H01L 21/60

(54) **EINE HYBRIDE HALBLEITERSTRUKTUR**
A HYBRID SEMICONDUCTOR STRUCTURE
UNE STRUCTURE SEMICONDUCTRICE HYBRIDE

(30) Priorität: 12.10.1990 DE 4032397
(43) Veröffentlichungstag der Anmeldung: 28.07.1993
(73) Patentinhaber: ROBERT BOSCH GMBH, 70442 Stuttgart (DE)
(72) Erfinder: GADEMANN, Lothar, D-7407 Rottenburg (DE); FLOHRS, Peter, D-7410 Reutlingen 11 (DE); HARTMANN, Juergen, D-7410 Reutlingen (DE)
(86) Internationale Anmeldenummer: DE9100789
(87) Internationale Veröffentlichungsnummer: WO9207378

(56) Entgegenhaltungen:
- EP-A- 0 265 077
- DE-A- 2 658 302
- DE-A- 4 008 624
- FR-A- 2 492 164
- FEINWERKTECHNIK + MESSTECHNIK. Bd. 92, Nr. 2, März 1984, MÜNCHEN, DE Seiten 67 - 69; M. HOF: 'Klebetechniken in der Mikroelektronik'

## Beschreibung

### Stand der Technik

Die Erfindung betrifft eine hybride Haltleiterstruktur nach der Gattung des unabhängigen Patentanspruchs.

Aus der US-PS 32 92 240 (siehe auch DE-PS 12 33 448) und aus der US-PS 33 03 393 sind bereits Verfahren zur Herstellung hybrider Halbleiterstrukturen nach der Gattung des Hauptanspruchs bekannt. Die Kontaktierung eines Halbleiterchipsubstrats auf einem Trägerplattensubstrat wird hierbei jeweils durch Metallkugel-Kontakte gebildet, die mit den Chipanschlußflecken des Halbleiterchipsubstrats einerseits und mit den zugehörigen Trägeranschlußflecken des Trägerplattensubstrats andererseits jeweils unter Verwendung von Blei-Zinn-Weichlot verlötet werden.

Eine Weiterbildung dieses bekannten Verfahrens der sogenannten Flip-Chip-Technologie besteht nach der US-PS 35 17 279 (siehe auch DE-AS 16 27 762) darin, daß auf die Metallkugeln verzichtet wird und auf die Chipanschlußflecken und/oder auf die Trägeranschlußflecken eine Weichlotschicht aufgebracht wird und die hybride Haltleiterstruktur allein mit Hilfe dieser Weichlotschicht im Reflow-Solder-Verfahren zusammengelötet wird.

Des weiteren ist es aus der DE-AS 16 14 374 bekannt, auf mindestens einen Teil der Oberfläche eines mit metallischen Anschlußflecken versehenen Halbleiterchipsubstrats eine Passivierungsschicht aufzubringen.

Weitere Vorrichtungen sind in den Documenten EP-A-265077 und DE-A-4008624 beschrieben.

Ein Nachteil der bekannten Verfahren der Flip-Chip-Technologie besteht darin, daß es schwierig ist, das Weichlot auf die Chipanschlußflecken und/oder auf die Trägeranschlußflecken in einer Menge aufzubringen und beim Aufschmelzen dort zu behalten, mit der einerseits eine zuverlässige mechanische und elektrisch leitende Verbindung zwischen den betreffenden Anschlußflecken erreicht wird, andererseits ein Kurzschluß einander benachbarter Anschlußflecken vermieden wird. Ein weiterer Nachteil besteht darin, daß bei großflächigen Halbleiterchip- oder Halbleiterwafersubstraten die hybride Halbleiterstruktur wegen der unterschiedlichen thermischen Ausdehnung der beiden Substrate einer Scherbelastung ausgesetzt ist, die durch die starre Lötverbindung der beiden Substrate bedingt ist.

### Vorteile der Erfindung

Das Verfahren hat demgegenüber den Vorteil, daß infolge der Elastizität der verwendeten elektrisch leitenden Klebeschicht auch großflächige Halbleiterchip- oder Halbleiterwafersubstrate in einer hybriden Halbleiterstruktur untergebracht werden können, ohne daß dabei bei der fertigen hybriden Halbleiterstruktur Scherbelastungen auftreten, die durch die unterschiedliche thermische Ausdehnung der beiden Substrate bedingt sind. Eine nach dem Verfahren hergestellte hybride Halbleiterstruktur ist durch den unabhängigen Patentanspruch gekennzeichnet.

### Zeichnung

Anhand der Zeichnung wird die Erfindung näher erläutert. Es zeigen:
Figur 1 einen Teil einer bekannten, in Flip-Chip-Technologie ausgeführten hybriden Halbleiterstruktur in vereinfachter Darstellung im Schnitt,
Figur 2 einen Ausschnitt aus einer erfindungsgemäßen hybriden Halbleiterstruktur in perspektivischer Darstellung vor dem Aufsetzen des Halbleiterchip- oder Halbleiterwafersubstrats auf das Trägerplattensubstrat,
Figur 3 eine Schnittdarstellung eines für die Kontaktierung vorbereiteten Trägerplattensubstrats,
Figur 4a eine Schnittdarstellung eines für die Kontaktierung vorbereiteten, als Diode ausgebildeten Halbleiterchipsubstrats,
Figur 4b das Halbleiterchipsubstrat nach Figur 4a in der Draufsicht, entlang der Symmetrielinie abgeschnitten,
Figur 5 eine Draufsicht eines für die Kontaktierung vorbereiteten, als Transistor ausgebildeten Halbleiterchipsubstrats,
Figur 6 eine schematische Schnittdarstellung einer erfindungsgemäßen hybriden Halbleiterstruktur, bei der die beiden Substrate mit ihren Anschlußflecken relativ zueinander ausgerichtet und miteinander verklebt sind.

### Beschreibung der Erfindung

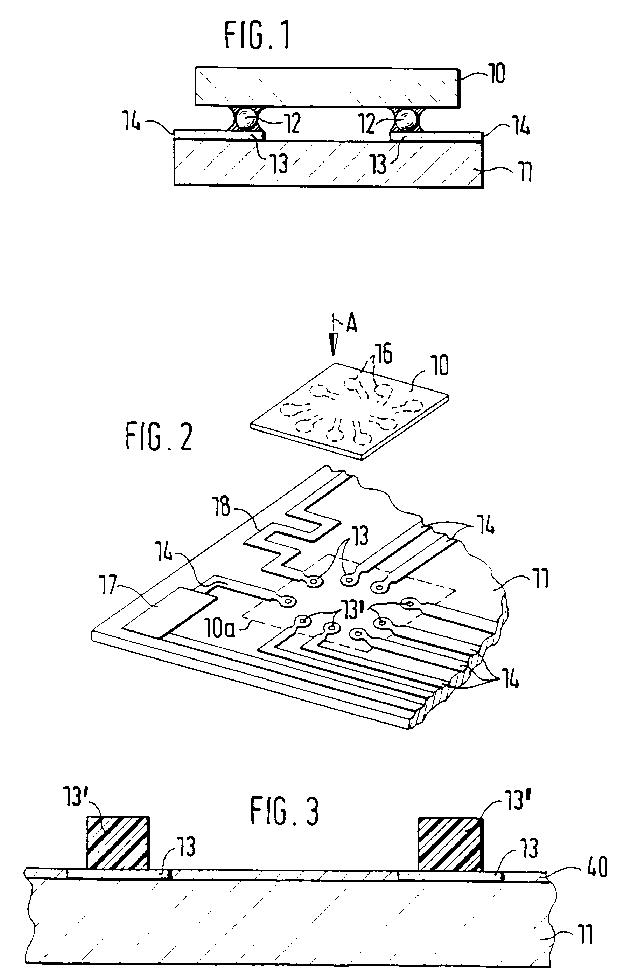

Figur 1 zeigt einen Ausschnitt aus der aus der US-PS 33 03 393 bekannten, in Flip-Chip-Technologie ausgeführten hybriden Halbleiterstruktur. Die Kontaktierung des Halbleiterchipsubstrats 10 auf dem Trägerplattensubstrat 11 ist hierbei durch Metallkugel-Kontakte 12 gebildet, die an den in Figur 1 nicht dargestellten metallischen Anschlußflecken des Halbleiterchipsubstrats 10 angebracht sind. Die Metallkugel-Kontakte 12, die aus Blei-Zinn-Weichlot bestehen, sind mit den nicht dargestellten metallischen Chipanschlußflecken des Halbleiterchipsubstrats 10 und mit den zugeordneten metallischen Trägeranschlußflecken 13 des Trägerplattensubstrats 11 unter Verwendung von Blei-Zinn-Weichlot verlötet. Die metallischen Trägeranschlußflecken 13 stellen jeweils den Endbereich einer Leiterbahn 14 eines Schaltungsmusters dar, das auf das Trägerplattensubstrat 11 aufgebracht ist.

Figur 2 zeigt einen Ausschnitt aus einer erfindungsgemäßen hybriden Halbleiterstruktur in perspektivischer Darstellung vor dem Aufsetzen des Halbleiterchip- oder Halbleiterwafersubstrats 10 auf das Trägerplattensubstrat 11, das in Pfeilrichtung A der Figur 2 erfolgt. Mit gestricheltem Linienzug 10a ist hierbei auf dem Trägerplattensubstrat 11 diejenige Stelle angedeutet, auf der das Halbleiterchip- oder Halbleiterwafersubstrat 10 beim Aufkleben auf das Trägerplattensubstrat 11 positioniert wird. Das Substrat 10 gemäß Figur 2 weist an seiner Unterseite eine Anzahl von Chipanschlußflecken 16 auf, die in Figur 2 ebenfalls gestrichelt angedeutet sind. Auf die die genannten Chipanschlußflecken 16 aufweisende Unterseite des Substrats 10 ist im Bereich außerhalb der Anschlußflecken 16 eine in Figur 2 nicht dargestellte Passivierungsschicht aufgebracht. Die Trägeranschlußflecken auf dem Trägerplattensubstrat 11 sind in Figur 2 wieder mit 13, die zugeordneten Leiterbahnen wieder mit 14 bezeichnet. Als Bestandteil eines Schaltungsmusters des Trägerplattensubstrats 11 ist in Figur 2 bei 17 beziehungsweise 18 ein Dickschichtwiderstand beziehungsweise ein Dünnschichtwiderstand angedeutet. Auf das das Schaltungsmuster aufweisende Trägerplattensubstrat 11 ist im Bereich außerhalb der Trägeranschlußflecken 13 eine in Figur 2 nicht dargestellte Passivierungsschicht aufgebracht. Um die elektrisch leitende Verbindung zwischen den metallischen Anschlußflecken 16 des Halbleiterchip- oder Halbleiterwafersubstrats 10 und den metallischen Anschlußflecken 13 des Trägerplattensubstrats 11 herstellen zu können, sind auf die Anschlußflecken 13 jeweils elektrisch leitende Klebeschichten 13' aufgebracht, die im Siebdruckverfahren hergestellt worden sind.

Beim Aufsetzen des Halbleiterchip- oder Halbleiterwafersubstrats 10 auf das Trägerplattensubstrat 11 in der in Figur 2 gestrichelt angedeuteten Lage wird die mechanisch feste und elektrisch leitende Verbindung zwischen den metallischen Chipanschlußflecken 16 des Substrats 10 und den metallischen Trägeranschlußflecken 13 des Substrats 11 dadurch hergestellt, daß die genannten Anschlußflecken 16 und 13 mittels der im Siebdruckverfahren aufgebrachten Klebeschichten 13' miteinander verklebt werden.

In Figur 3 ist ein Schnitt durch das Trägerplattensubstrat 11 der Figur 2 dargestellt, der zwei einander benachbarte Trägeranschlußflecken 13 schneidet. Im Bereich außerhalb der Trägeranschlußflecken 13 ist auf das Trägerplattensubstrat 11 ganzflächig eine Passivierungsschicht 40 aufgebracht. Auf das das Schaltungsmuster tragende, mit der Passivierungsschicht 40 versehene Trägerplattensubstrat 11 sind selektiv im Bereich der Trägeranschlußflecken 13 die elektrisch leitenden Klebeschichten 13' im Siebdruckverfahren aufgebracht worden. Man erkennt, daß die Klebeschichten 13' die Trägeranschlußflecken 13 jeweils nicht vollständig abdecken.

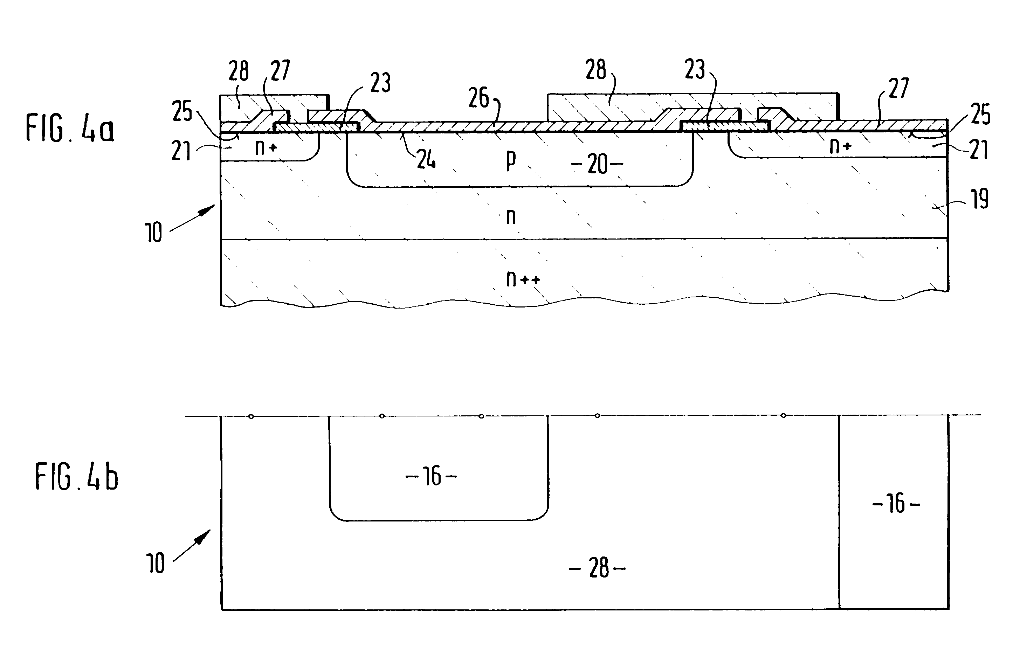

Der Aufbau eines bei dem Verfahren einsetzbaren Halbleiterchip- oder Halbleiterwafersubstrats 10 wird zunächst anhand der Figuren 4a und 4b am Ausführungsbeispiel eines Halbleiterchipsubstrats erläutert, das als in Planartechnik ausgeführte Diode ausgebildet ist. Die Erfindung ist vielmehr dazu geeignet und dient dem Zweck, die bekannten Flip-Chip-Technologie so abzuwandeln, daß sie auf hybride Halbleiterstrukturen ausgedehnt werden können, die besonders großflächige Halbleiterchip- oder Halbleiterwafersubstrate wie beispielsweise auch Transistoren, intergrierte Schaltungen, SCRs enthalten.

In einen scheibenförmigen, aus einkristallinem Silicium bestehenden Halbleiterkörper 19 vom n-Leitfähigkeitstyp - eine inverse Schichtenfolge ist ebenfalls denkbar - ist von seiner Oberseite her eine p-leitende Anodenzone 20 und um diese Anodenzone herum eine n⁺-dotierte ringförmige Kathodenzone 21 eindiffundiert. Als Folge dieser Diffusionsprozesse ist an der genannten Oberseite des Halbleiterkörpers 19 eine Siliciumdioxidschicht 23 ausgebildet. Zur Kontaktierung der Anodenzone 20 und der Kathodenzone 21 sind in die Siliciumdioxidschicht 23 Kontaktfenster 24 beziehungsweise 25 eingeätzt. Das Kontaktfenster 25 umgibt hierbei das Kontaktfenster 24 ringförmig. Auf die Anodenzone 20 ist im Bereich des Kontaktfensters 24 eine Metallisierung 26 aufgebracht, auf die Kathodenzone 21 im Bereich des ringförmig ausgebildeten Kontaktfensters 25 eine Metallisierung 27. Die Metallisierungen 26, 27 erstrecken sich an ihren Rändern ein wenig auch über die Siliciumdioxidschicht 23. Die Metallisierungen 26, 27 können aus Metallen wie Aluminium, Nickel oder Gold oder aus Legierungen dieser Metalle mit anderen Metallen bestehen. Eine besonders geeignete Legierung besteht hierbei aus einer Aluminium-Nickel-Silber-Legierung.

Auf den mit der Siliciumdioxidschicht 23 und den Metallisierungen 26, 27 versehenen Halbleiterkörper 19 ist zum Beispiel mit Hilfe der Fotomaskierungstechnik eine Passivierungsschicht 28 aufgebracht worden. Die Passivierungsschicht 28 dient zur zusätzlichen Passivierung der Teile der Siliciumdioxidschicht 23, die nicht von den Metallisierungen 26, 27 bedeckt werden, und außerdem zur Definition der Flächenausdehnung der Chipanschlußflecken 16, indem diejenigen Oberflächenbereiche der Metallisierungen 26, 27, die nicht für den äußeren Chipanschluß herangezogen werden sollen, durch die Passivierungsschicht 28 abgedeckt werden. Die nicht durch die Passivierungssicht 28 abgedeckten Teile der Metallisierungen 26, 27 stellen also die Chipanschlußflecken 16 dar.

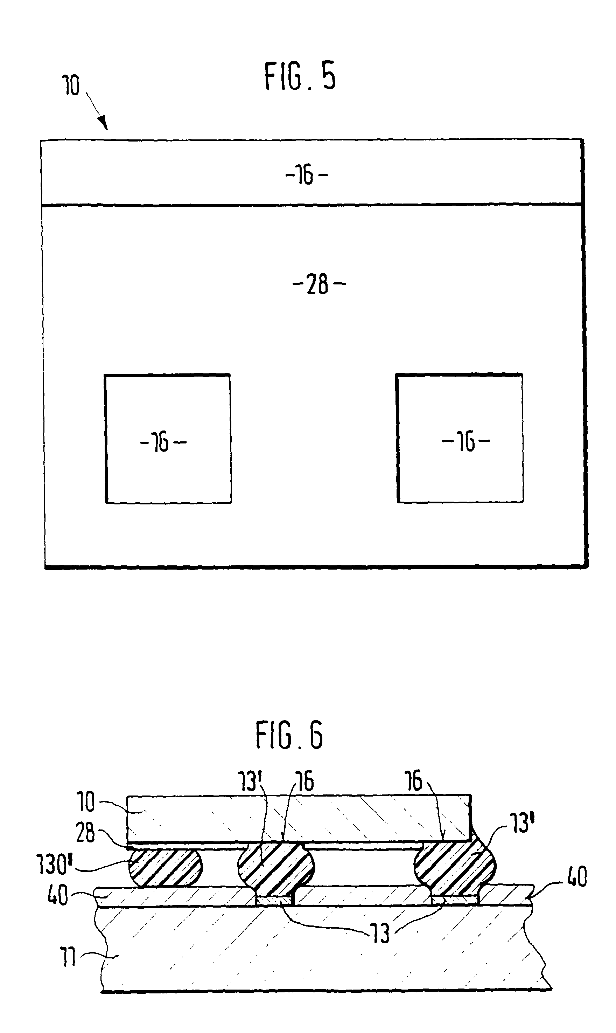

In Figur 5 ist ein für die Kontaktierung vorbereitetes, als Transistor ausgebildetes Halbleiterchipsubstrat 10 in der Draufsicht dargestellt. Auch hier werden die Chipanschlußflecken 16 mit Hilfe einer Passivierungsschicht 28 als durch die Passivierungsschicht nicht abgedeckte Teilbereiche von Metallisierungen definiert, mit denen die entsprechenden Zonen (Emitter, Basis und Kollektor) des Transistors kontaktiert sind.

Die Herstellung der erfindungsgemäßen hybriden Halbleiterstruktur geschieht in folgender Weise:

Auf das mit dem Schaltungsmuster und der Passivierungsschicht 40 versehene Trägerplattensubstrat 11 werden zuerst mit Hilfe des Siebdruckverfahrens innerhalb der Bereiche der Trägeranschlußflecken 13 elektrisch leitende Klebeschichten 13' aufgebracht. Dann wird auf das so vorbereitete Trägerplattensubstrat 11 das Halbleiterchip- oder Halbleiterwafersubstrat 10 derart aufgesetzt, daß die Chipanschlußflecken 16 mit den Trägeranschlußflecken 13 mittels der Klebeschichten 13' in Berührung kommen. Durch Aneinanderdrücken der beiden Substrate 10, 11 werden die Chipanschlußflecken 16 mit den Trägeranschlußflecken 13 mit Hilfe der Klebeschichten 13' verklebt (Figur 6).

Die nassen Klebeschichten 13' werden durch den Aufsetzdruck des "face-down"-montierten Halbleiterchipsubstrats 10 so weit verbreitert, daß die gesamten Oberflächen der Anschlußflecken 13, 16 benetzt werden, ohne daß dabei ein ausreichender Abstand zu potentialfremden Anschlußflecken unterschritten wird. Nach dem Aushärten der Klebeschichten 13' kann damit eine hinreichend geringe Schichtdicke (zum Beispiel d = 45 micrometer bei kreisförmigem Anschlußfleck mit r > 280 micrometer) mit einem für Halbleiter typischen Rth < 1,3 K/W realisiert werden.

Dem Aufsetzdruck wirkt die Kohäsion des nassen Leitklebers entgegen. Diese Wirkung kann bei wenigpoligen Bauelementen (zum Beispiel Dioden, Transistoren) durch zusätzliche Blindkontakte vergrößert und stabilisiert werden, wenn die Anschlußflecken 16 beziehungsweise 13 nicht gleichmäßig über die Oberfläche des Halbleiterchip- oder Halbleiterwafersubstrats 10 beziehungsweise des Trägerplattensubstrats 11 verteilt sein sollten und deshalb die Gefahr besteht, daß sich die beiden Substrate 10, 11 beim Aneinanderdrücken verkanten. Die Blindkontakte bestehen darin, daß außer den zur Kontaktierung dienenden Klebeschichten 13' auf die Oberfläche des Trägerplattensubstrats 11 im Bereich außerhalb der Trägeranschlußflecken 13 noch eine oder mehrere weitere Klebeschichten 130' aufgebracht werden (Figur 6), die gemeinsam mit den Klebeschichten 13' im Siebdruckverfahren hergestellt werden. Die so gebildeten Blindkontakte wirken dann beim Aneinanderdrücken der beiden Substrate wie Abstandshalter, so daß ein gleichmäßig über die Gesamtheit der Kontakte verteilter Aufsetzdruck entsteht. Außerdem entstehen durch die Blindkontakte zusätzliche Übergangsstellen zur Wärmeableitung.

Bei wenigpoligen Bauelementen ist der durch die minimalen Größen der Anschlußflecken und Abstände vorgegebene Flächenbedarf zwar geringfügig größer als bei bisherigen "face-up"-montierten Halbleitern, bei Berücksichtigung der dabei erforderlichen Bondverbindungen aber wesentlich kleiner. Bei vielpoligen Bauelementen können die Außenanschlüsse bei entsprechendem IC-Design matrixförmig über die Oberfläche verteilt angeordnet werden. Dann ist der Platzbedarf im Vergleich zu peripher angeordneten "Bondpads" erheblich geringer und nur noch durch die auf dem Substrat mögliche Anschlußdichte der Leiterbahnen bestimmt.

Das Trägerplattensubstrat 11 kann aus Aluminiumoxid (Al₂O₃) oder aus Aluminiumnitrid (AlN) oder aus Glas oder aus jeder geeigneten Schichtstruktur (zum Beispiel Tape on Substrate, Multilayer), mit der eine hinreichend ebene Oberfläche erzeugt werden kann, bestehen.

## Patentansprüche

1. Zusammengesetzte hybride Halbleiterstruktur mit einem Trägerplattensubstrat (11), einer Anzahl von mindestens zwei Trägeranschlußflecken (13) auf einer Oberfläche des Trägerplattensubstrats (11), einem Halbleiterchip- oder Halbleiterwafersubstrat (10), einer Anzahl von mindestens zwei Chipanschlußflecken (16) auf einer Oberfläche des Haltleiterchip- oder Halbleiterwafersubstrats (10), gekennzeichnet durch je eine thermisch und elektrisch leitende Klebeschicht (13') auf der Oberfläche des Trägerplattensubstrats (11) innerhalb der Bereiche der Trägeranschlußflecken (13), wobei die genannten Substrate (10, 11) mit den genannten Anschlußflecken (13, 16) einander gegenüberliegend und in elektrisch leitender und mechanisch fester Verbindung durch die genannten elektrisch leitenden Klebeschichten (13') miteinander in Verbindung gebracht sind, und weiterhin gekennzeichnet durch mindestens eine weitere thermisch und elektrisch leitende Klebeschicht (130') auf der Oberfläche des Trägerplattensubstrats (11) außerhalb der Bereiche der Trägeranschlußflecken (13) zur Verbesserung der mechanisch festen Verbindung der genannten Substrate (10, 11) und zur Verbesserung der Wärmeableitung.

## Claims

1. Composite hybrid semiconductor structure having a mount substrate (11), a number of at least two mount pads (13) on a surface of the mount substrate (11), a semiconductor chip or semiconductor wafer substrate (10), a number of at least two chip pads (16) on a surface of the semiconductor chip or semiconductor wafer substrate (10), characterized by a respective thermally and electrically conductive adhesive layer (13') on the surface of the mount substrate (11) within the regions of the mount pads (13), the said substrates (10, 11) being connected together with the said pads (13, 16) opposite one another and in an electrically conductive and mechanically fixed connection by means of the said electrically conductive adhesive layers (13'), and furthermore characterized by at least one further thermally and electrically conductive adhesive layer (130') on the surface of the mount substrate (11) outside the regions of the mount pads (13), for the purpose of improving the mechanically fixed connection of the said substrates (10, 11) and for the purpose of improving the heat dissipation.

## Revendications

1. Structure de semi-conducteur hybride assemblée avec un substrat (11) constituant une plaque de support comportant un nombre d'au moins deux pièces de raccordement du support (13) sur une surface du substrat (11) constituant une plaque de support, avec un substrat (10) de puces de semi-conducteur ou de plaquettes de semi-conducteur, un nombre d'au moins deux pièces de raccordement de puces (16) sur une surface du substrat (10) de puces de semi-conducteur ou de plaquettes de semi-conducteur,
caractérisée par
respectivement une couche adhésive (13') thermiquement et électriquement conductrice sur la surface du substrat (11) ; à l'intérieur des zones des pièces (13) de raccordement de support, ces substrats (10, 11) étant mis en liaison avec ces pièces de raccordement (13, 16) se faisant vis-à-vis l'une l'autre et en liaison fixe mécaniquement et électriquement conductrice par les couches adhésives (13') électriquement conductrices et
caractérisée en outre par
au moins une autre couche adhésive (13') thermiquement et électriquement conductrice sur la surface du substrat (11), constituant une plaque de support en dehors des zones des pièces de raccordement du support (13) pour améliorer la liaison mécaniquement fixe de ces substrats (10, 11) et pour améliorer l'évacuation de la chaleur.
